# EUROPEAN PATENT APPLICATION

(11) **EP 4 589 777 A1**
(43) Date of publication of application: **23.07.2025**
(21) Application number: 24152514.6
(22) Date of filing: 18.01.2024
(51) Int. Cl.: H01R 4/02

(54) **CONTACT ASSEMBLY AND ELECTRICAL DEVICE INCLUDING A CONTACT ASSEMBLY**

(71) Applicant: TE Connectivity Solutions GmbH, 8200 Schaffhausen (CH)
(72) Inventor: KRAEMER, Christoph, 8200 Schaffhausen (CH); WEINERTH, Walter, 8200 Schaffhausen (CH); GLASER, Karlheinz, 8200 Schaffhausen (CH); EBERLE, Marcus, 8200 Schaffhausen (CH); GRUENDLER, Jens, 8200 Schaffhausen (CH)
(74) Representative: Grünecker Patent- und Rechtsanwälte PartG mbB

(57) **Abstract**

A contact assembly (600) is disclosed, including a conductor (300), which can be a busbar, and a plurality of conductive contact pins (100, 100a, 100b). The conductive contact pins (100, 100a, 100b) are welded, such as stud welded, to the conductor (300). The conductive contact pins (100, 100a, 100b) can extend through a housing (400). The distal end of the plurality of conductive contact pins can be press-fit into a PCB, which may include conductive vias which electrically connect to the distal ends of the conductive contact pins (100). An electrical device, which may be a measurement device such as for measuring current, is disclosed which includes the contact assembly (600).

## Description

Contact assemblies can be used in the fabrication of electrical devices and/or systems, such as for sensing and/or measurement. Herein is disclosed a contact assembly, an electrical device that includes a contact assembly, and a measurement device that includes a contact assembly.

There is a desire for fabrication of contact assemblies and electrical devices that meet challenging manufacturing tolerances and maintain high rates of manufacture. There is a further desire to keep manufacturing costs low. For contact assemblies that are used in conjunction with conductors such as busbars, such as those suitable for conducting high currents, challenges can arise in making conductive attachments. The relatively high mass of busbars compared to other electrical components can impact the strength of attachment between busbars and other components. For example, relatively high mass materials with high heat capacities, such as conductors like busbars, can influence the resulting physical characteristics of the formed welds, as well as the dynamic characteristics of the welding process.

Herein is disclosed a contact assembly, including a conductor, such as a busbar, and a plurality of conductive contact pins attached thereto. The plurality of conductive contact pins is welded to the conductor. The welded conductive contact pins can be used to robustly connect to a variety of different structures, and make electrical connections, e.g. between the conductor and additional devices like sensors. Conductive contact pins, which can be flexible and/or elastic, can protect against deleterious effects of thermal expansion and contraction.

The conductor can include a shunt located between two of the conductive contact pins, such as one used in a current measurement device. Alternatively/additionally, a shunt between a pair of conductive contact pins may facilitate attachment of a device, such as an electrical and/or measurement device to the conductor.

Stud welding can be used to weld contact pins to the conductor. Stud welding can allow precise positioning of the contact pin onto the conductor and/or provide a strong weld. Alternatively/additionally, stud welding can save time in comparison to other welding techniques.

The contact pins can extend through a housing of the contact assembly. The housing can thermally insulate the distal end of the pins from the conductor, and/or electrically insulate the region at the distal end of the pins from the conductor. Alternatively/additionally, the housing can aid in positioning the contact pins and/or provide mechanical support to the pins. The housing can include holes through which the contact pins extend, and the housing can include collars around the holes for the contact pins. Collars can provide additional mechanical stabilization to the pins. For example, a gap can be provided between the top surface of the conductor and the housing and/or collar thereof, such as at the hole of the housing through which the pin passes.

The housing can attach to the conductor, such as by flanges that may abut the top surface of the conductor. The housing can, alternatively/additionally, have holes for fixing the housing to the conductor.

The contact assembly can include a cover that extends above the distal ends of the contact pins. The cover can protect components of the contact assembly, such as the contact pins, a printed circuit board, and/or circuitry. The cover can attach to the housing. The cover and housing can surround a printed circuit board, PCB. The cover and housing can, particularly in combination, protect other components such as pins and/or a PCB.

The contact assembly can include a PCB. A distal end of the conductive contact pins can connect to the PCB, such as by press-fitting the distal end into the PCB. The connection, by the conductive contact pins, of the conductor to the PCB can allow circuitry of the PCB to be electrically coupled to the conductor. Press-fitting can be rapid, and reduce manufacturing time. For example, an electrical connection to the PCB can allow the formation of an electrical device, such as a measurement device, such as a current measurement device. The distal ends of the pins can be press-fit into vias of the PCB, e.g. conductive vias. Press-fitting the pins into vias can rapidly establish mechanical contact. Conductive vias of the PCB can rapidly and/or inexpensively establish electrical contacts between the PCB and the conductor when the pins are press-fit into conductive vias. Soldering the pins to the PCB is possible as an alternative or additional measure, which can aid in forming robust electrical connections. As an additional measure, soldering can increase the lifetime of the contact and/or provide redundancy in the electrical connection. Soldering can, for example, electrically connect to solder pads on a surface of the PCB.

Herein is disclosed an electrical device, such as a measurement device, such as for measuring current. The electrical device can include any contact assembly described herein, and at least one PCB connected to a distal end of the pins. The electrical device can include a circuit which includes the pins and the PCB, which may be used for measurement. Herein is disclosed a measurement device, such as for measuring current, that includes any contact assembly described herein or any electrical device described herein.

The conductor of the measurement device can include a material, between two pins, of negligibly small temperature coefficient of resistance, for example Manganin. A thermally stable resistance of the material between the pins (e.g. a shunt) can aid in providing accurate measurements, such as accurate current measurements. A thermally stable resistance can be particularly desirable for applications involving busbars, which may carry high current and/or may generate considerable heat during operation.

Herein is disclosed the use of a conductive contact pin to electrically connect a PCB and a conductor by welding an end of the conductive contact pin to the conductor. The conductor can be a busbar, and/or can include a shunt. Alternatively/additionally, the conductive contact pin has a transversely compressible end configured for press-fitting into another component, such as a via, e.g. a conductive via of a PCB.

Herein is disclosed a method of making a contact assembly, the method including welding (preferably stud welding) a plurality of conductive contact pins to a conductor (300).

In the following, embodiments are explained with reference to the drawings. Features of embodiments can be combined with one another as desired, such as in accordance with the above general description, such as to make a further embodiment. A feature may be omitted from an embodiment, e.g. if a technical effect of the feature is not required in a particular application. Any feature described herein, with respect to one embodiment, can be included in a second embodiment, such as in a further embodiment, unless inclusion of the feature would contradict the description of the second embodiment.

In the following, the same reference numerals are used for features that correspond to each other with respect to at least one of structure or function. Reference numerals and drawings are intended to aid explanation of the variously described embodiments. Reference numerals and the drawings are not intended to be limiting of the invention, which is defined by the claims.

In the drawings:
- Fig. 1A: shows a contact assembly, according to an embodiment;
- Fig. 1B: shows a contact assembly, according to an embodiment;
- Fig. 2: shows a contact assembly, according to an embodiment;
- Fig. 3: shows a contact assembly, according to an embodiment;
- Fig. 4: shows a conductive contact pin, according to an embodiment;
- Fig. 5: shows a housing and conductor, according to an embodiment;
- Fig. 6: shows a housing, conductor, and pins, according to an embodiment;
- Fig. 7: shows a housing, conductor, pins, and a PCB, according to an embodiment;
- Fig. 8: shows a housing, conductor, pins, PCB, and a cover, according to an embodiment;
- Fig. 9: shows a contact assembly, according to an embodiment; and
- Fig. 10: shows a pin and clamp, according to an embodiment.

Herein, "conductive contact pins," "pins," and "contact pins" are used interchangeably. Herein, transverse is perpendicular to longitudinal, and may be perpendicular to a main axis of a conductive contact pin. Herein, a sensor can be a kind of measurement device.

Herein, "stud welding" can be an arc welding process in which the pin(s) and conductor are the electrodes. Stud welding can be performed while a pressing force is applied between the pin and the conductor. Herein, stud welding can be by capacitor discharge, which may allow even faster weld formation. Herein, a pin-PCB interface can be a press-fit connection. Herein, a pin-conductor interface can be a weld.

Herein, the conductor can be a busbar, such as a copper busbar, which may be, for example, of 2 to 8 mm thickness. Herein, a busbar can include steel, aluminum, and/or combined materials, for example.

Herein, a negligibly small temperature coefficient of resistance can be less than 100 ppm per Kelvin, or varying less than 2% from 0 to 1000C. An example of a material with a negligibly small temperature coefficient of resistance is Manganin. Herein, a shunt can be a resistive shunt. Herein, the terms proximate and proximal are used interchangeably. Herein an (s) at the end of a word means one or more; for example a hole(s) is one or more holes. Herein "and/or" means at least one of the listed elements. For example, "A and/or B" means: only A; only B, at least A; at least B; or at least A and B. For example, "X, Y, and/or Z" means: only X; only Y; only Z; at least X; at least Y; at least Z; only X and Y; only X and Z; only Y and Z; only X, Y, and Z; at least X and Y; at least X and Z; at least Y and Z; or at least X, Y, and Z.

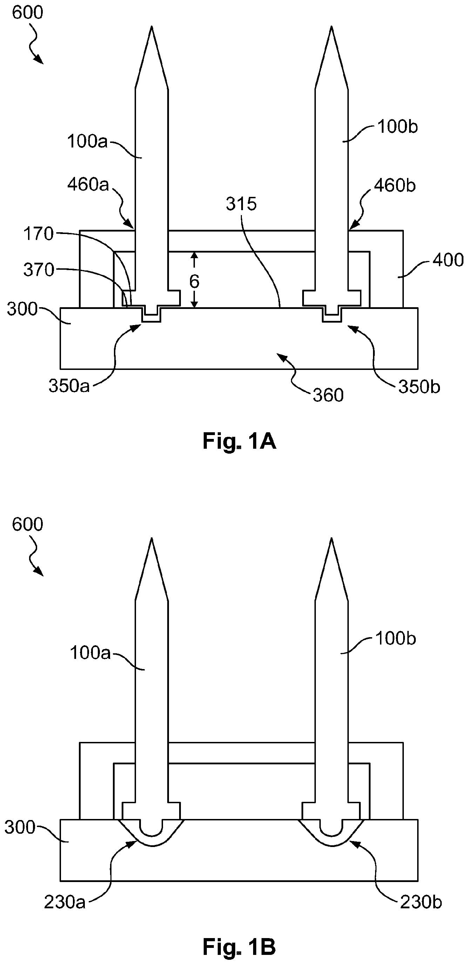

Fig. 1A shows a contact assembly 600, according to an embodiment. A contact assembly 600 includes conductive contact pins 100a, 100b which are welded to a conductor 300, such a busbar. As in Fig. 1A, a contact assembly 600 can have a contact pin 100a and a second contact pin 100b, however, in every embodiment described herein, there can be more than two contact pins 100a, 100b. The pins 100a, 100b can be resistively welded, Tig welded, or stud welded to the conductor 300. Stud welding may allow more rapid fabrication of the contact assembly. For example, a comparatively large conductor 300, such as a busbar, may have a high heat capacity and may be relatively slow to heat and/or require comparatively high energy to melt and/or weld. Stud welding may advantageously allow rapid localized melting and/or joining of the conductor 300 and the pin 100a, 100b. Stud welding can form a weld in, for example 3 to 100 ms, or possibly shorter durations. Stud welding may alternatively/additionally allow precise positioning of the contact pin 100a, 100b onto the conductor 300 and/or provide a strong weld.

The contact assembly 600 can include a housing 400, such as that shown in Fig. 1. The pins 100a, 100b can extend through the housing 400. The housing 400 can provide mechanical support to the pins 100a, 100b. For example, the pins 100a, 100b pass through respective holes 460a, 460b of the housing 400. There can be a gap 6 between the housing 400 and the conductor 300, such as at the holes 460a, 460b. The position of the holes 460a, 460b away from the top surface 315 of the conductor 300 can provide improved support to the pin 100a, 100b. The housing 400, such as the holes 460a, 460b thereof, can alternatively/additionally allow for alignment of the pins 100a, 100b.

The pins 100a, 100b can be welded to the top surface 315 of the conductor 300 and/or be welded to respective recesses 350a, 350b of the top surface 315. Recesses 350a, 350b can be provided for alignment of the pins 100a, 100b with the surface 315 of the conductor 300. Recesses 350a, 350b can be provided for each pin location.

The top surface 315 of the conductor 300 can include a joining surface 370 which can be joined to a joining surface 170 of the pins 100a, 100b. The joining surfaces 170, 370 can be adjacent the recesses 350.

At a region 360 of the conductor 300 between the pins 100a, 100b, there can be shunt, e.g. a shunt resistor. Alternatively/additionally, the region 360 can include a material of negligibly small temperature coefficient of resistance, such as Manganin. A shunt resistor can allow multiple functionalities of the pins 100a, 100b, for example in forming circuits based on the shunt resistor between the welded ends of the pins 100a, 100b. With a shunt in the region 360 between the pins 100a, 100b, as in Fig. 1A, the contact assembly 600 can provide electrical functionality that function with (e.g. connect to) many different types of circuits, sensors, measurement devices, control devices, and/or feedback devices.

Fig. 1B shows a contact assembly 600, according to an embodiment. A contact assembly 600 can include any of the features of the embodiments explained above, such as with reference to Fig. 1A. As in Fig. 1A, a contact assembly 600 has a contact pin 100a and a second contact pin 100b, and more pins are possible. As shown in Fig. 1B, there are conductive contact pins 100a, 100b which are welded to a conductor 300, such a busbar. Welds, such as the welds formed by the welding described herein, can form welding nuggets 230a, 230b, as shown in Fig. 1B. The welding nuggets 230a, 230 shown in Fig. 1B can be representative of the result of the welding used for making any contact assembly 600 described herein.

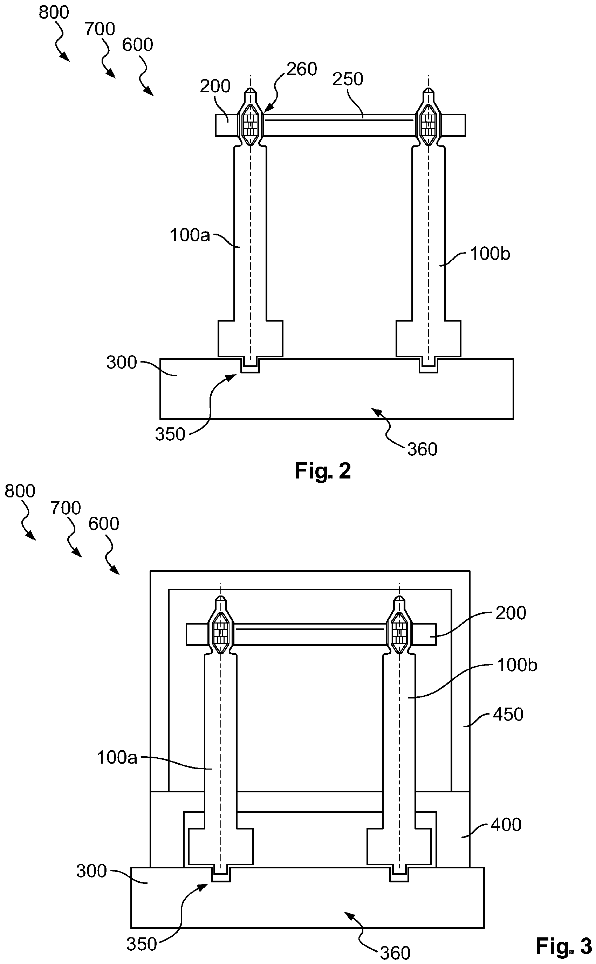

Fig. 2 shows a contact assembly 600 according to an embodiment. A contact assembly 600 can include any of the features of the embodiments explained above, such as with reference to Fig. 1A or 1B. A contact assembly 600 can include a PCB 200, such as the PCB 200 shown in Fig.2, which can include a circuit 250. The PCB can include vias 260, such as conductive vias, which may make electrical contact with the distal ends of the pins 100a, 100b. Electrical connection between the PCB 200 and the pins 100a, 100b can occur within the vias 260 and/or by soldering to pads of the PCB circuit 250. The pins 100a, 100b can be press-fit into the vias. Press-fitting can allow rapid manufacture of the contact assembly 600. Soldering can aid in ensuring good electrical contact between the pins 100a, 100b and the PCB 200, including when vias 260 which are conductive are also used.

It can be advantageous to use a housing 400, such as when the pins 100a, 100b are long and flexible. Relatively long pins 100 can allow for greater displacement due to thermal effects, e.g. being elastic and/or flexible, such that the contact assemblies described herein are protected from thermal expansion and/or contraction. The housing 400 can reduce mechanical strain and/or vibrations being transmitted to the connections at the pin-PCB interface and/or the pin-conductor interface.

An electrical device 700 may include circuitry configured to pass current from the first pin 100a to the second pin 100b (e.g. through a circuit 250 of the PCB 200), and/or to measure the potential difference between the first pin 100a to the second pin 100b, as in an example of a measurement device 800. The electrical device 700 may be communicatively coupled to a further device (not shown). The electrical device 700 can be, for example, a current measurement device, a current limiter, and/or an overload protector.

Fig. 3 shows a contact assembly 600 according to an embodiment. The contact assembly 600 can include any of the features of the embodiments of contact assemblies explained above, such as with reference to Figs. 1A, 1B, and/or 2. The contact assembly 600 can include a cover 450. The cover 450 can protect the pins 100a, 100b and/or the PCB 200 from the environment, such as by surrounding the PCB 200 and or pins 100a, 100b. The cover 450 can work with the housing 400 for environmental protection of the PCB 200, pins 100a, 100b, and/or any sensitive components of the contact assembly 600, such as circuit components on the PCB 200. The cover 450 and/or housing 400 can also protect users from contacting high voltages.

The cover 450 and/or housing 400 can be made of thermoplastic. The contact assembly 600 can be made at low cost when using common materials such as thermoplastic which is adequately strong and/or insulative.

Fig. 2, as well as Fig. 3, also illustrate an electrical device 700 and/or a measurement device 800, which include the contact assembly 600.

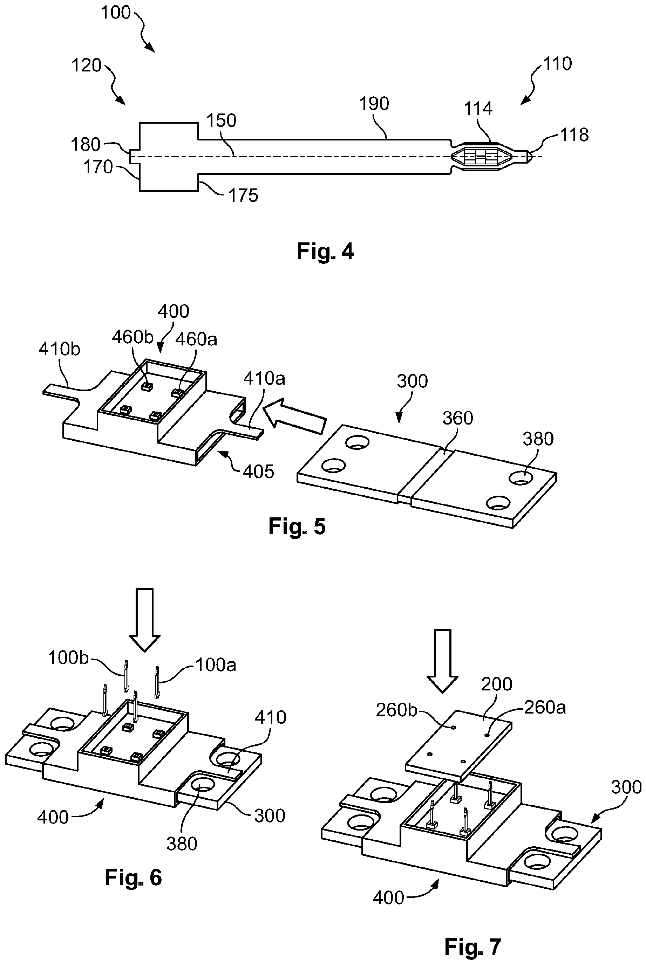

Fig. 4 shows an embodiment of a conductive contact pin 100. The conductive contact pins 100 described herein can be used in combination with any contact assembly 600, electrical device 700, and/or measurement device 800 described herein.

As shown in Fig. 4, a pin 100 has a main axis 150 which can extend from a proximal end 120 to a distal end 110. The main axis 150 can be an axis of highest symmetry. Herein, the proximate end 120 is used for welding to the conductor 300, and the distal end 110 can be used for making an electrical connection, such as to a PCB 200, e.g. by press-fitting.

The distal end 110, which can include a compressible region 114, can be press-fit into a via of a PCB 200. The distal end 110 can include a tip 118 which is smaller in the transverse direction (transverse being perpendicular to the main axis 150) than the compressible region 114. The distal end 110 can form a friction lock with a PCB via. The compressible region 114 can include a spring functionality. For example, the compressible region 114 is elastically deformable, e.g. in a direction transverse to the main axis 150 of the pin 100. The compressible region 114 can be of the same size or smaller, in a transverse, direction than a shaft 190 that connects the distal end 110 to the proximal end 120.

A pin 100 can include a joining surface 170 at the proximate end 120. The joining surface 170 can abut the surface of the conductor 300, e.g. while being welded, and a weld formed between the joining surface 170 of the pin 100 and a complementary joining surface 370 of the conductor 300.

Shown in Fig. 4 is a pin 100 with a high aspect ratio; the pin 100 shown has a length along the main axis 150 which is significantly greater than the largest width in the transverse direction. The greatest width in the transverse direction may be at a joining surface 170 and/or shoulder 175. Relatively high aspect ratio pins 100, e.g. those having an aspect ratio of from 3 to 10, or even higher, can provide a relatively large distance between the conductor 300 and the PCB 200. A relatively large distance can aid in protecting the PCB 200 from effects related to the heat generated by the conductor 300 (which may be a busbar), e.g. thermal effects. A pin 100 having a shorter aspect ratio, e.g. below 3, can be advantageous when thermal effects, such as expansion and/or contraction, is less of a concern than other problems, such as vibrations or mechanical shocks which might cause an electrical disconnection. Shorter aspect ratio pins may be more resistant to deformation due to compressive forces, and may increase the lifetime of contact assemblies 600 that are at risk of exposure to compressive forces.

Shown in Fig. 4 is an optional projection 180 at the proximate end 120, which can aid during the welding process. The projection 180 can be along the main axis 150. The projection 180 may concentrate electric field lines during arc welding, for example, and/or stud welding, to localize the heat generated while welding the pin 100 to the conductor 300. Alternatively/additionally, the projection 180 may melt, at least partially, and form part of the weld, e.g. by melting and mixing with the melted conductor 300 at the weld. The projection 180 can aid in formation of a sturdy weld in a short time. The joining surface 170 can lie on opposite sides of the projection 180, extending along the transverse and/or radial directions. The pin 100 can be made from a flat piece of metal or a cylindrical piece of metal, for example.

The conductor 300 may, optionally, have a hole 380 (e.g. a blind hole) to aid in positioning of the pin when welding, e.g. a hole 380 which accepts the projection 180 at the proximate end 120 of the pin. The use of a projection 180 with a complementary hole 380 of the conductor 300 can aid in proper positioning and/or orientation of the pin 100. A complementary hole 380 of the conductor 300 can be approximately 20-150 micrometers, e.g. 50-100 micrometers, deep. Alternatively/additionally, the weld can be done to a flat surface of the conductor 300, which can save processing time.

For example, the projection 180 extends 0.4-1.0 mm from the joining surface 170 along the main axis 150. The width of the shoulder 175 and/or joining surface 170 can extend, transversely and/or radially, to about 0.5 to 3 mm from the main axis 150. The shaft 190 can be about 0.75 to 2 mm wide in the transverse direction, perpendicular to the main axis 150, and be narrower than the shoulder 175 and/or the joining surface 170.

Shown in Fig. 4 is an optional shoulder 175. The shoulder 175 can be opposite the joining surface 170 along the main axis 150. The shoulder 170 can extend transversely the same distance from the main axis 190 as the joining surface 170. A shoulder 175 can provide a surface for accepting a force along the main axis direction during welding. The shoulder 175 can aid in formation of a sturdy weld in a short time. The shoulder 175 can be the widest feature of the pin 100 in the transverse direction. Alternatively/additionally, the shoulder 175 may be wider than the hole of the housing 400 through which the pin 100 extends. A shoulder 175 and/or joining surface 170 may aid in quickly forming a strong weld.

Pins 100 can be elastic and/or flexible, such may protect the contact assemblies described herein from thermal expansion. Pins 100 may be action pins, and/or multisprings, for example. Pins 100 can be round or flat in cross section, for example. Pins here can be cold stamped, or made out of wire from a reel, e.g. with cold punches. Pins 100 can be electroplated, at least on the distal end 110, e.g. where the press-fit and/or compressible portion 114 may be. Electroplating may improve the electrical contact to the PCB, for example.

Pins may be made of copper alloys, such as CuSn4. Steel alloys are also possible, for example. Copper tin alloys are possible. Pins may be a monolithic material that may be electroplated. A monolithic material suitable for welding on the proximal end and having longevity as a press-fit material, e.g. maintaining elasticity, on the distal end is contemplated.

Fig. 5 shows a housing and conductor, according to an embodiment. The housing 400 can slide over the conductor 300. The housing can have a slot 405 for insertion of the conductor 300. Alternatively/additionally, the housing 400 can be attached to the conductor 300 with one or more fasteners, such as fastener(s) that go through a hole(s) 380 of the conductor. Fasteners can fasten a flange(s) 410a, 410b of the housing 400 to the conductor 300. The housing 400 can also include one or more holes 460a, 460b for the pin(s) 100. The hole(s) 460a, 460b can support the pin(s) 100a, 100b before and/or after welding the pin(s) 100 to the conductor 400.

Fig. 5 shows a region 360 of the conductor 300 between pins 100, e.g. between the welds formed at the junction of pins and the conductor 300. The region 360 can include a shunt, e.g. a resistive shunt.

Fig. 6 shows a housing 400, conductor 300, and pins 100a, 100b, according to an embodiment. The flange(s) 410a, 410b of the housing 400 can be placed adjacent hole(s) 380 of the conductor 300. Fasteners can press the flange(s) 410a, 410b against the conductor 380. A clamp, not shown, can guide the pin(s) through the hole(s) 460a, 460b of the housing 400, and/or provide a pole of an arc welding device for arc welding the pin to the conductor 300; e.g. for stud welding.

Fig. 7 shows a housing 400, conductor 300, pins 100, and a PCB 200, according to an embodiment. The distal end of the pin(s) 100 can be inserted into a PCB 200, e.g. after welding the pin(s) 100 to the conductor 300. The distal ends 110 of the pin(s) 100 can make electrical contact with the PCB 200. For example, electrical contact can be made with conductive vias 260a, 260b of the PCB 200.

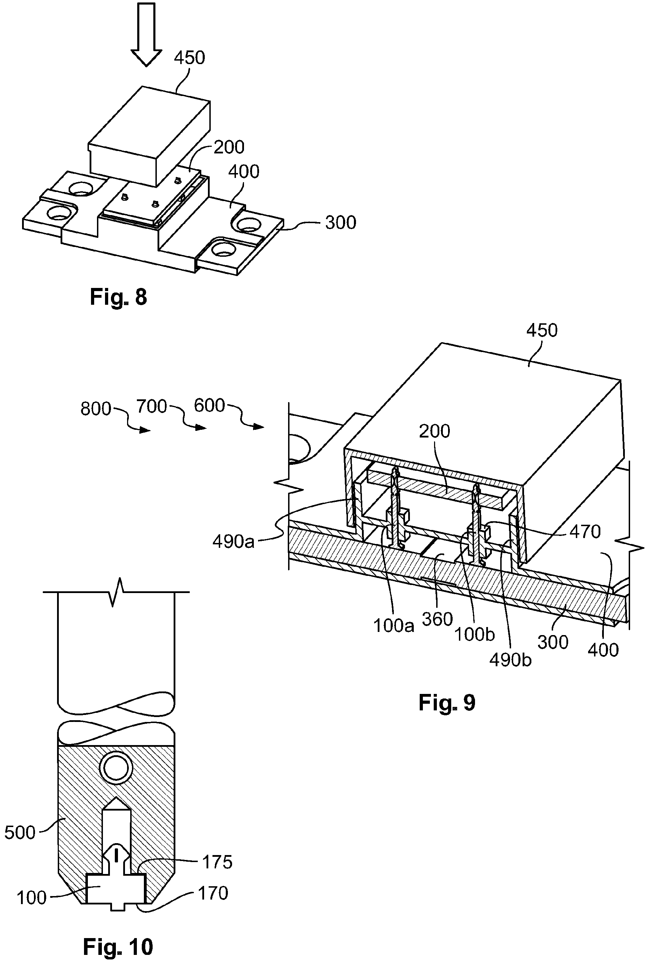

Fig. 8 shows a housing 400, conductor 300, pins 100, a PCB 200, and a cover 450, according to an embodiment. The cover 450 can make an interference fit with the housing 400. Alternatively/additionally, the cover 450 can be attached with an adhesive, which can prevent the cover 450 from coming loose.

Figs. 5-8 can illustrate an assembly process in which the pin(s) 100 are inserted through the housing hole(s) 460a, 460b after the housing 400 is placed on the conductor 300. Pin(s) can be welded after the housing 400 is placed on the conductor 300; the housing 400 can aid in positioning the pin(s) 100 prior to the weld, e.g. such that the weld is formed when the pins (100) are optimally oriented according to the placement of the housing 400.

Alternatively, pin(s) 100 can be welded to the conductor 300 before the housing 400 is placed on the conductor 300. Pin(s) 100 that are welded to the conductor 300 before the housing 400 is placed on the conductor 300 can be inserted through the hole(s) 460a, 460b of the housing 400 before welding, e.g. when the housing 400 is placed on the conductor 300 without the use of a slot 405. Welding before placement of the housing 400 can be rapid. The welding process may involve use of a clamp 500 to hold the pin(s) which may apply a force which is transmitted as a contact force between the conductor 300 and the pin(s) 100. If the welding is done before the housing 400 is located on the conductor 300, the pin(s) 100 can be held closer to the proximal end 120, which may allow a greater contact force to be used, which may allow for more rapid welding. The pin(s) 100 can be inserted through the hole(s) 460a, 460b, after the weld. The housing 400, placed on the conductor 300, after welding, can aid in orienting and/or positioning the pin(s) 100, e.g. to aid in accurate connection to the PCB 200. Pin(s) 100, after welding to the conductor 300, may be adequately flexible to allow some mechanical orientation of the pin(s) 100 by the housing 400 and/or PCB vias 260.

Herein, pin position can be accurate to within 0.05 mm.

Fig. 9 shows a contact assembly 600, according to an embodiment. A contact assembly 600 includes a conductor 300 and pins 100a, 100b. The optional housing 400, which can be part of any contact assembly 600 described herein, can include collar(s) 470 around the hole (460) through which the pin(s) 100 extend. Collar(s) 470 can provide mechanical support to the pin(s) 100. The collar(s) 470 can extend in a vertical direction from at least one side of the housing 400. The collar(s) 470 can be a thicker region of the housing 400, e.g. a thicker region of thermoplastic. The collar(s) 470 can be positioned above a gap 6 (see Fig. 1A) between the collar(s) 470 and the conductor 300. The use of collar(s) 470 can aid in the mechanical stability of the pin(s) 100, such as when the pin(s) 100 are relatively high aspect ratio and/or long and/or a gap 6 is between the collar(s) 470 and the conductor 300. Alternatively/additionally, the collar(s) 470 can aid in the positioning and/or orientation of the pin(s) 100.

A contact assembly 600 can include a region 360 between pins 100 where a shunt can be located, as shown in Fig.10. A shunt can include a material of negligibly small temperature coefficient of resistance, such as Manganin. Many circuits, such as measurement circuits are more accurate and/or reliable when shunts of negligibly small temperature coefficient of resistance are used.

A contact assembly 600 can include a cover 450, such as the cover 450 as shown in Fig. 9. The cover 450 may contact a top surface of the housing 400 and/or vertical wall(s) 490a, 490b of the housing which extend upward in the same direction as the pins 100. The housing 400, e.g. the vertical walls 490a, 490b thereof, and the cover 450 can attach by an interference fit and/or use of an adhesive. A cover 450 can extend above the distal end of the pins 100, and/or above the PCB 200. The cover 450 and housing 400 can surround the PCB 200, e.g. to protect the PCB 200 from the environment.

Fig. 10 illustrates a pin and clamp. During welding, a pin 100 can be held by a clamp 500. The clamp 500 can apply a force, especially to the shoulder 175 of the pin 100, during welding. The applied force can result in a contact force at the joining surface 170 of the pin 100 and a complementary joining surface 370 of the conductor 300, which can reduce the time required to form the weld.

The clamp 500 can include, or be made of, CuCr or CuCrZr, for example.

The pin 100 shown in Fig. 10 has a relatively small aspect ratio of approximately 1, having a width (transverse direction) approximately equal to the length (vertical direction, along the main axis 150). A pin 100 having a relatively short aspect ratio, e.g. below 3 (such as from 0.5 to 2), can be advantageous when the contact assembly is implemented in environments subject to vibrations or mechanical shocks. Short aspect ratio pins may reduce a risk of breakage at the distal end 110, e.g. where the electrical connection is made to a PCB 200, for example. Contact assemblies described herein that are made from relatively short aspect ratio, e.g. below 3 (such as from 0.5 to 2), may omit the housing 400, or use a housing 400 that does not include, for each pin 100, a respective hole 460. Alternatively/additionally, a pin 100 having a relatively short aspect ratio, e.g. below 3 (such as from 0.5 to 2), can resist buckling forces, e.g. in the compressive direction.

Herein is disclosed the use of a conductive contact pin 100 to electrically connect a printed circuit board, PCB 200, and a conductor 300, by welding an end 120 of the conductive contact pin 100 to the conductor 300. The conductor can be a busbar including a shunt. Alternatively/additionally, the conductive contact pin 100 has a transversely compressible portion 114, e.g. a distal end 120 with a transversely compressible portion 114 which can make electrical contact with a PCB 200, e.g. a conductive via 260 thereof.

Herein is disclosed a method of making a contact assembly 600, including welding, such as stud welding, a plurality of conductive contact pins 100 to a conductor 300 (which can be a busbar, e.g. a busbar including a shunt). As described herein, the contact assembly 600 can include a housing 400, through which the pins 100 are inserted. The housing 400 can be attached to the conductor 300, as described herein. A cover 450 can be provided, such as attached to the housing 400, as described herein. A PCB 200 can be provided, such as a PCB connected to a distal end 110 of the pins 100, e.g. by press-fitting, e.g. in a via(s) 260 of the PCB 200 (such as conductive vias), as described herein, e.g. at a transversely compressible portion 114 of a distal end 110 of a pin 100. A circuit 250 of the PCB 200 can be included in the contact assembly 600, and the contact assembly 600 can be at least part of an electrical device 700, such as a measurement device 800, as described herein.

As an example of welding, a pin 100 can be poled with the negative polarity, and the conductor 300 the positive polarity. As an example, power of approximately 1500-8000 watts can be applied, e.g. with 0.8-1.8 volts. Alternatively/additionally, a pulse of approximately 2 kW can be used, in combination with a 50-100 micrometer hole 380 on the conductor 300 and complementary projection 180 on the pin 100, as positioning aids. Alternatively/additionally, a pulse of approximately 4 kA at 0.9 volts can be used. A weld can be formed that is approximately 500-600 micrometers thickness. In yet another example, the weld can use a 10 ms pulse of 1 kW. In another example, the pulse is 3-4 kA for 8 ms. During welding, a pressing force of from 30-100 N, or 50-70 N, can be applied, for example.

The description and drawings referred to in the description provide examples of various embodiments. The invention is defined by the claims.

### REFERENCE NUMERALS

- 6: gap

- 100: contact pin
- 100a: first pin
- 100b: second pin
- 110: distal end
- 114: compressible portion
- 118: tip
- 120: proximate end
- 150: main axis
- 170: joining surface
- 175: shoulder
- 180: projection
- 190: shaft
- 200: PCB
- 230a: weld nugget
- 230b: weld nugget
- 250: PCB circuit
- 260: PCB via
- 260a: PCB via
- 260b: PCB via
- 300: conductor
- 315: top surface of conductor
- 350: recess
- 350a: recess
- 350b: recess
- 360: region
- 370: contact surface
- 380: attachment hole
- 400: housing
- 401: housing
- 405: slot
- 410a: flange
- 410b: flange
- 450: cover
- 460a: housing hole
- 460b: housing hole
- 461: housing attachment hole
- 470: collar
- 490a: first vertical wall
- 490b: second vertical wall
- 500: clamp
- 600: contact assembly
- 700: electrical device
- 800: measurement device

## Claims

1. A contact assembly (600), comprising:
a conductor (300), and
a plurality of conductive contact pins (100, 100a, 100b), including a first pin and a second pin, wherein
the plurality of conductive contact pins (100, 100a, 100b) is welded to the conductor (300).

2. The contact assembly (600) of claim 1, wherein
the plurality of conductive contact pins (100, 100a, 100b) is stud welded to the conductor (300).

3. The contact assembly (600) of claim 1 or 2, further comprising:
a housing (400), wherein the plurality of conductive contact pins (100) extends through the housing (400).

4. The contact assembly (600) of any one of claims 1-3, further comprising:
a cover (450) which extends above the distal ends (110) of the plurality of conductive contact pins (100, 100a, 100b).

5. The contact assembly (600) of any one of claims 1 to 4, wherein
the conductor (300) is a busbar including a shunt, and wherein
the shunt is between the first and second pins.

6. The contact assembly (600) of any one of claims 1 to 5, further comprising:
a printed circuit board, PCB (200), connected to a distal end of the plurality of conductive contact pins (100, 100a, 100b).

7. The contact assembly (600) of claim 6, wherein
the distal end of the plurality of conductive contact pins (100, 100a, 100b) is press-fit into the PCB.

8. The contact assembly of claim 5, 6, or 7, further comprising:
a plurality of conductive vias (260) of the PCB (200) which electrically connect to the distal ends (110) of the plurality of conductive contact pins (100).

9. An electrical device, comprising:
the contact assembly of any one of claims 6 to 8; and
a circuit which includes the plurality of conductive contact pins and the PCB.

10. A measurement device (600), such as for measuring current, comprising:
the contact assembly (600) of any one of claims 1 to 8 or the electrical device of claim 9.

11. The measurement device (600) of claim 10, wherein
between the first and second pins (100a, 100b), the conductor (300) includes a material of negligibly small temperature coefficient of resistance, such as Manganin.

12. Use of a conductive contact pin (100) to electrically connect a printed circuit board, PCB (200), and a conductor (300), by
welding an end (120) of the conductive contact pin (100) to the conductor (300).

13. The use of the conductive contact pin (100) of claim 12, wherein
the conductor is a busbar including a shunt.

14. The use of the conductive contact pin (100) of claim 12 or 13, wherein
the conductive contact pin has a transversely compressible end.

15. A method of making a contact assembly, comprising,
welding, preferably stud welding, a plurality of conductive contact pins (100, 100a, 100b) which include a first pin and a second pin to a conductor (300).
